# EUROPEAN PATENT SPECIFICATION

(11) **EP 4 362 076 B1**
(45) Date of publication and mention of the grant of the patent: **04.02.2026**
(21) Application number: 23205501.2
(22) Date of filing: 24.10.2023
(51) Int. Cl.: H01L 23/00

(54) **BONDING STRUCTURE AND POWER DEVICE**
VERBINDUNGSSTRUKTUR UND LEISTUNGSVORRICHTUNG
STRUCTURE DE LIAISON ET DISPOSITIF D'ALIMENTATION

(30) Priority: 31.10.2022 CN 202211349206
(43) Date of publication of application: 01.05.2024
(73) Proprietor: Huawei Digital Power Technologies Co., Ltd., Shenzhen, 518043 (CN)
(72) Inventor: Lu, Fenglong, Shenzhen, 518043 (CN); Chen, Dong, Shenzhen, 518043 (CN); Shi, Lei, Shenzhen, 518043 (CN); Tang, Yunyu, Shenzhen, 518043 (CN); Liu, Yunfeng, Shenzhen, 518043 (CN)
(74) Representative: Epping - Hermann - Fischer

(56) References cited:
- EP-A1- 2 393 111
- CN-U- 207 624 692
- JP-A- 2006 165 151
- JP-A- 2007 157 958
- JP-A- 2017 157 604
- US-A1- 2010 213 566
- US-A1- 2015 294 930
- US-A1- 2020 395 331
- US-A1- 2021 217 724

## Description

### TECHNICAL FIELD

The present invention relates to the field of power module bonding technologies, and in particular, to a bonding structure and a power device.

### BACKGROUND

Power modules are core semiconductor components for power electronic conversion. As the power modules develop towards higher power density, more requirements are put forward for a packaging technology of the power modules. For a power module with a large current, electrical connections between components in the power module are mainly implemented through bonding wires.

The power module includes a substrate and bonding wires. A wafer (for example, a chip) is disposed on the substrate. During packaging of the power module, a back side of the wafer is welded to the substrate, a front side of the wafer is connected to a plurality of bonding wires, and the plurality of bonding wires are separately led out to another wafer or another substrate, to form a power current loop. Reliability of the bonding wires is crucial during packaging. However, in a wire-leading manner in a related technology, the bonding wires are prone to fatigue due to fluctuating stress, thereby reducing service lives of the bonding wires and affecting bonding effect.

US 2010/213566 A1 describes wirebond forms to couple an opto-electronic device chip to a signal processing chip. A first wirebond, a second wirebond and a third wirebond define a first wirebond group corresponding to a first channel. All three of first, second and third wirebonds cross each other in a star-shaped arrangement, in other embodiments they can cross each other in other arrangements.

US 2020/395331 A1 describes a wire bonding structure. A first signal electrode and a second signal electrode are connected by a first wire, a first ground electrode and a fourth ground electrode are connected by a second wire, and a second ground electrode and a third ground electrode are connected by a third wire. The second wire and the third wire cross at only one position above the first wire.

### SUMMARY

The invention is set out in the appended set of claims. Embodiments of this application provide a bonding structure and a power device. Spatial cross wire bonding is performed on bonding wires, so that lead paths of the bonding wires form an angle with each other, thereby weakening electromagnetic force between the bonding wires. Therefore, fatigue due to fluctuating stress of the bonding wires can be alleviated, service lives of the bonding wires can be prolonged, and bonding effect can be ensured to a maximum extent.

According to a first aspect, an embodiment of this application provides a bonding structure, including a first power unit and at least two bonding wires. At least one end of the bonding wire is connected to the first power unit through bonding. Projections that are of lead paths of the at least two bonding wires and that are on a preset plane have one intersection point. The preset plane is parallel to the first power unit.

The bonding structure provided in this embodiment of this application includes the first power unit and the bonding wires. The at least one end of the bonding wire is connected to the first power unit through bonding. Therefore, an electrical connection can be implemented between two devices in the first power unit or between the first power unit and a neighboring power module such as a second power unit, to form a power current loop. The bonding structure includes the at least two bonding wires. The projections that are of the lead paths of the at least two bonding wires and that are on the preset plane have the at least one intersection point. In this way, the bonding wires can form an angle with each other, so that electromagnetic force between neighboring bonding wires can be weakened when an alternating current passes through the bonding wires. Therefore, fatigue due to fluctuating stress of the bonding wires can be alleviated, service lives of the bonding wires can be prolonged, and bonding effect can be ensured to a maximum extent.

The projections that are of the lead paths of the at least two bonding wires and that are on the preset plane have one intersection point. The projections that are of the lead paths of the at least two bonding wires and that are on the preset plane are set to have one intersection point, so that the bonding wires can form an angle with each other, and electromagnetic force on the bonding wires are in disorder, thereby weakening electromagnetic force between the bonding wire and another neighboring bonding wire. Therefore, fatigue due to fluctuating stress of the bonding wires can be alleviated, service lives of the bonding wires can be prolonged, and bonding effect can be ensured to a maximum extent.

The first power unit has at least two bonding points. The at least two bonding wires are connected to the at least two bonding points in a one-to-one correspondence through bonding.

The plurality of bonding wires form a plurality of bonding units. The plurality of bonding units are spaced in an arrangement direction of the at least two bonding points. The plurality of bonding wires form the plurality of bonding units. The plurality of bonding units are spaced in the arrangement direction of the at least two bonding points. In this bonding manner, electromagnetic force between the bonding wires can be weakened. Therefore, fatigue due to fluctuating stress of the bonding wires can be alleviated, and service lives of the bonding wires can be prolonged.
at least three of the plurality of bonding wires form a bonding unit. Projections that are of lead paths of at least two of the at least three bonding wires and that are on the preset plane have no intersection point. A projection that is of a lead path of another bonding wire and that is on the preset plane and the projections that are of the lead paths of the at least two bonding wires and that are on the preset plane each have at least one intersection point. In this bonding manner, electromagnetic force between the bonding wires can also be weakened. Therefore, fatigue due to fluctuating stress of the bonding wires can be alleviated, and service lives of the bonding wires can be prolonged.

In a possible implementation, one end of the bonding wire is connected to the first power unit through bonding, and the other end of the bonding wire is connected to the outside of the first power unit through bonding.

One end of the bonding wire is connected to the first power unit through bonding, and the other end of the bonding wire is connected to the outside of the first power unit through bonding. In this bonding manner, the electrical connection can be implemented between the first power unit and the neighboring power module such as the second power unit. In addition, at least one intersection point may fall on a plane on which the first power unit is located, a plane on which the second power unit is located, or a preset plane other than planes on which the first power unit and the second power unit are located.

In a possible implementation, two ends of the bonding wire are both connected to the first power unit through bonding, and the preset plane is a plane on which the first power unit is located.

The two ends of the bonding wire are both connected to the first power unit through bonding. In this bonding manner, the electrical connection can be implemented between the two devices in the first power unit. In addition, at least one intersection point falls on the plane on which the first power unit is located.

In a possible implementation, the bonding structure further includes a second power unit. One end of the bonding wire is connected to the first power unit through bonding, and the other end of the bonding wire is connected to the second power unit through bonding.

The second power unit is included, so that the electrical connection can be implemented between devices of the first power unit and the second power unit, to form a power current loop.

In a possible implementation, the first power unit is a first substrate; or the first power unit is a first wafer; or the first power unit includes a first substrate and a first wafer disposed on the first substrate, and the bonding wire is connected to the first wafer through bonding.

When the first power unit is set to the first substrate, two ends of the bonding wire are both connected to the first substrate through bonding, to implement the electrical connection between the two devices in the first substrate; and at least one intersection point falls on a plane on which the first substrate is located. When the first power unit is set to the first wafer, two ends of the bonding wire are both connected to the first wafer through bonding, and at least one intersection point falls on a plane on which the first wafer is located. When the first power unit is set to include the first substrate and the first wafer disposed on the first substrate, one end of the bonding wire is connected to the first wafer through bonding, and the other end of the bonding wire is connected to the second power unit through bonding. Bonding manners are diverse.

In a possible implementation, the second power unit is a second substrate; or the second power unit is a second wafer; or the second power unit includes a second substrate and a second wafer disposed on the second substrate, and the bonding wire is connected to the second wafer through bonding.

When the second power unit is set to the second substrate, two ends of the bonding wire are both connected to the second substrate through bonding, to implement the electrical connection between the two devices in the second substrate; and at least one intersection point falls on a plane on which the second substrate is located. When the second power unit is set to the second wafer, two ends of the bonding wire are both connected to the second wafer through bonding, and at least one intersection point falls on a plane on which the second wafer is located. When the second power unit is set to include the second substrate and the second wafer disposed on the second substrate, one end of the bonding wire is connected to the first wafer through bonding, and the other end of the bonding wire is connected to the second wafer or the second substrate through bonding. Bonding manners are diverse.

According to a second aspect, an embodiment of this application provides a power device, including the foregoing bonding structure.

These and other aspects, implementations, and advantages of the example embodiments become apparent with reference to the accompanying drawings and based on the embodiments described below. However, it should be understood that this specification and the accompanying drawings are merely intended for description and are not used as definitions that limit this application. For details, refer to the appended claims. Other aspects and advantages of this application will be described in the following description. Some aspects and advantages are apparent in the description or are learned of through practice of this application. In addition, the aspects and advantages of this application may be implemented and obtained by using the means particularly specified in the appended claims or a combination thereof.

### BRIEF DESCRIPTION OF DRAWINGS

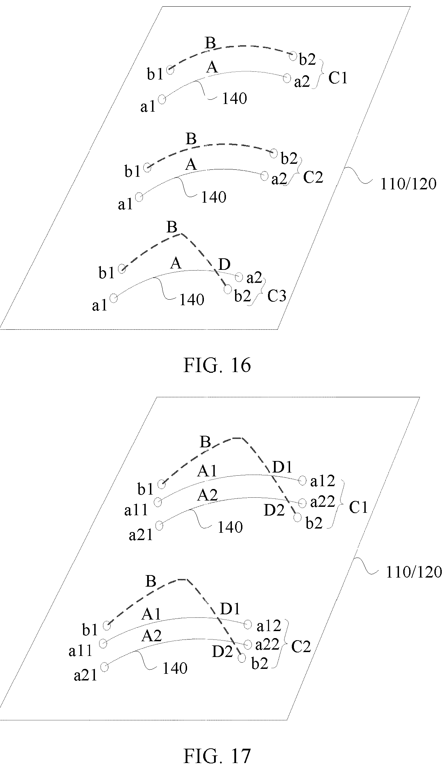

The embodiment detailed along Figure 17 is according to the claimed invention. Embodiments described along other figures are not according to the claimed invention and are useful for understanding the invention.
FIG. 1 is a schematic diagram of a structure of a bonding structure according to an embodiment of this application;
FIG. 2 is a schematic diagram of a structure in which bonding wires are bonded to a first wafer and an intersection point falls on a plane on which the first wafer is located according to Embodiment 1 of this application;
FIG. 3 is a schematic diagram of a structure in which bonding wires are bonded to a first wafer and an intersection point falls on a preset plane according to Embodiment 1 of this application;
FIG. 4 is a schematic diagram of a structure in which bonding wires are bonded to a first substrate and an intersection point falls on a plane on which the first substrate is located according to Embodiment 2 of this application;
FIG. 5 is a schematic diagram of a structure in which bonding wires are bonded to a first substrate and an intersection point falls on a preset plane according to Embodiment 2 of this application;
FIG. 6 is a schematic diagram of a structure in which bonding wires are bonded to a first wafer and a second wafer and an intersection point falls on a plane on which the first wafer is located according to Embodiment 3 of this application;
FIG. 7 is a schematic diagram of a structure in which bonding wires are bonded to a first wafer and a second wafer and an intersection point falls on a preset plane according to Embodiment 3 of this application;
FIG. 8 is a schematic diagram of a structure in which bonding wires are bonded to a first wafer and a second wafer and an intersection point falls on a plane on which the second wafer is located according to Embodiment 3 of this application;
FIG. 9 is a schematic diagram of a structure in which bonding wires are bonded to a first substrate and a second substrate and an intersection point falls on a plane on which the first substrate is located according to Embodiment 4 of this application;
FIG. 10 is a schematic diagram of a structure in which bonding wires are bonded to a first substrate and a second substrate and an intersection point falls on a preset plane according to Embodiment 4 of this application;
FIG. 11 is a schematic diagram of a structure in which bonding wires are bonded to a first substrate and a second substrate and an intersection point falls on a plane on which the second substrate is located according to Embodiment 4 of this application;
FIG. 12 is a schematic diagram of a structure in which bonding wires are bonded to a first wafer and a second substrate and an intersection point falls on a plane on which the first wafer is located according to Embodiment 5 of this application;
FIG. 13 is a schematic diagram of a structure in which bonding wires are bonded to a first wafer and a second substrate and an intersection point falls on a preset plane according to Embodiment 5 of this application;
FIG. 14 is a schematic diagram of a structure in which bonding wires are bonded to a first wafer and a second substrate and an intersection point falls on a plane on which the second substrate is located according to Embodiment 5 of this application;
FIG. 15 is a schematic diagram 1 of a structure in which bonding wires form bonding units according to Embodiment 6 of this application;
FIG. 16 is a schematic diagram 2 of a structure in which bonding wires form bonding units according to Embodiment 6 of this application;
FIG. 17 is a schematic diagram 3 of a structure in which bonding wires form bonding units according to Embodiment 6 of this application; and
FIG. 18 is a schematic diagram of a structure in which a maximum height of bonding wires is different from a maximum height of a first power unit according to Embodiment 7 of this application.

Description of reference numerals:
100: bonding structure; 110: first power unit; 111: first wafer;
112: first substrate; 120: second power unit; 121: second wafer;
122: second substrate; 130: preset plane; 140: bonding wire.

### DESCRIPTION OF EMBODIMENTS

Terms used in embodiments of this application are merely used to explain specific embodiments of this application, but are not intended to limit this application.

Power modules are core semiconductor components for power electronic conversion. The power module usually includes a wafer (for example, a chip), a substrate bearing the wafer, and another component.

The wafer is a silicon wafer used in manufacturing a silicon semiconductor integrated circuit. The wafer is of a round shape, and therefore is referred to as a wafer. Various circuit element structures may be manufactured on the silicon wafer, to form an integrated circuit product with a specific electrical function. An original material of the wafer is silicon. There is inexhaustible silicon dioxide on the surface of the earth's crust. Silicon dioxide ores are extracted by using an electric arc furnace, chlorinated by using hydrochloric acid, and then distilled to obtain high-purity polycrystalline silicon. The chip is also referred to as a microcircuit, a microchip, and an integrated circuit; and is a silicon chip that includes an integrated circuit. The chip has a small volume, and is usually a part of a computer or another electronic device.

A relationship between the wafer and the chip is as follows: The wafer is a carrier of the chip. During chip production, the wafer is directly produced instead of the chip. The wafer is fully used to obtain a specific quantity of chips, and is cut into pieces of chips.

The substrate includes but is not limited to various forms such as a laminated substrate and a frame substrate. A structure of the substrate includes a thermally conductive insulation layer and two metal layers. The two metal layers are respectively disposed on two opposite sides of the thermally conductive insulation layer. Specifically, during packaging, the wafer includes a wafer substrate (that may be silicon, glass, or the like), a pin, and a circuit located on a surface of the wafer substrate or inside the wafer substrate. The substrate has a bonding area. The wafer is disposed on a side that is of a metal layer and that is away from the thermally conductive insulation layer. The substrate can provide functions such as electrical connection, protection, support, and heat dissipation for the wafer, to implement a plurality of pins, reduce a volume of a packaged product, improve electrical performance and heat dissipation performance, implement ultra-high density, and implement multi-wafer modularization.

The pin of the wafer is connected to the bonding area on the substrate through bonding by using a bonding wire, to implement an electrical connection between the substrate and the wafer. The bonding wire is usually made of a metal material that includes but is not limited to a material such as gold, copper, or aluminum. A diameter of a metal bonding wire ranges from 15 µm to hundreds of micrometers according to a specific application requirement for a maximum power that can be borne by the bonding wire. When the diameter of the bonding wire becomes larger, the maximum power that can be borne by the bonding wire increases accordingly.

A specific working principle is as follows: When an alternating current passes through the bonding wire, it can be learned from the Ampere's law that a magnetic field is induced around the bonding wire, and the bonding wire presents an inductive characteristic. An inductance value of the bonding wire ranges from 0.3 nH to 1.5 nH based on different lengths and different diameters of the bonding wire. In a radio frequency stage, effect of externally radiating an electromagnetic field by the bonding wire is more significant. Therefore, when the wafer and the substrate are packaged, electromagnetic interference exists between bonding wires and between a bonding wire and another sensitive component.

In addition, with development of power modules towards a high speed, miniaturization, and integration, in consideration of a wire bonding process, cases in which bonding wires in wafer packaging are close to each other or even close to and parallel to each other increases. In this case, a spatial distance between the bonding wire and another sensitive component becomes smaller.

However, when the bonding wires are designed to be parallel to each other, there may be the following problems: In a case, when an alternating current passes through the bonding wires, and current flow directions of two neighboring bonding wires are the same, the neighboring bonding wires are stretched in directions away from each other under acting force of mutually repulsive magnetic fields. Therefore, the bonding wires are prone to fatigue due to fluctuating stress, thereby affecting reliability of the bonding wires. In another case, when an alternating current passes through the bonding wires, and current flow directions of two neighboring bonding wires are opposite, the neighboring bonding wires approach each other in directions facing each other under acting force of mutually attractive magnetic fields. Therefore, the bonding wires are also prone to fatigue due to fluctuating stress, thereby affecting reliability of the bonding wires.

Therefore, electromagnetic interference in the power module becomes increasingly obvious, and becomes an important factor that affects electrical performance of the power module. How to enhance electrical isolation between devices and weaken electromagnetic force (acting force of mutually repulsive magnetic fields or acting force of mutually attractive magnetic fields) between bonding wires in the foregoing environment becomes an urgent problem to be resolved in designing a power module. Currently, there is no technology that is directly related to weakening electromagnetic force between bonding wires.

On this basis, embodiments of this application provide a bonding structure and a power device. The bonding structure includes a first power unit and bonding wires. At least one end of the bonding wire is connected to the first power unit through bonding. Therefore, an electrical connection can be implemented between two devices in the first power unit or between the first power unit and a neighboring power module such as a second power unit, to form a power current loop. The bonding structure includes at least two bonding wires. Projections that are of lead paths of the at least two bonding wires and that are on a preset plane have at least one intersection point. In this way, lead paths of the bonding wires can form an angle with each other, so that electromagnetic force between neighboring bonding wires can be weakened when an alternating current passes through the bonding wires. Therefore, fatigue due to fluctuating stress of the bonding wires can be alleviated, service lives of the bonding wires can be prolonged, and bonding effect can be ensured to a maximum extent.

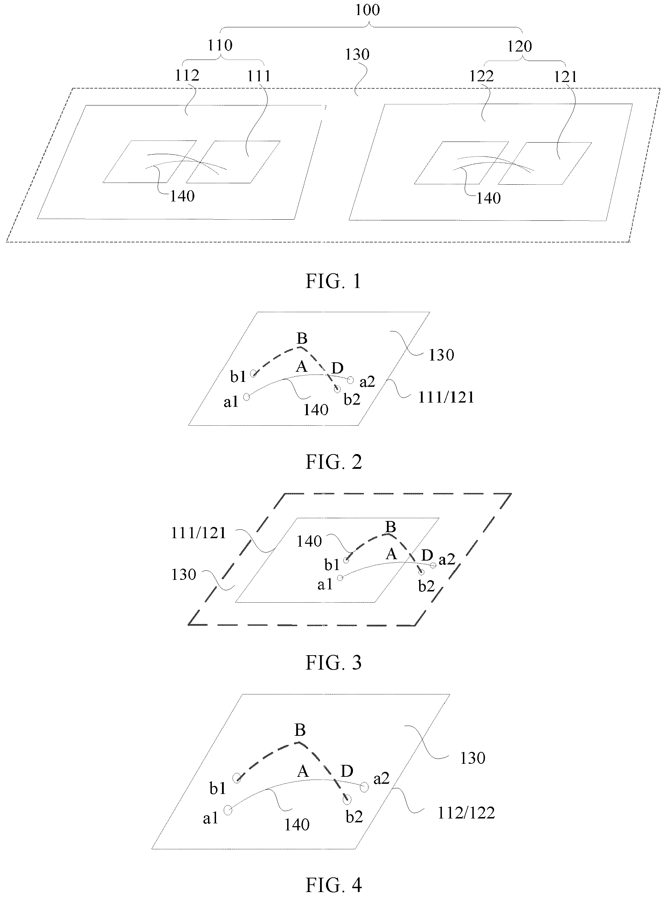

The following describes a specific structure of the bonding structure in detail with reference to FIG. 1 to FIG. 18.

FIG. 1 is a schematic diagram of a structure of a bonding structure according to an embodiment of this application. As shown in FIG. 1, this embodiment of this application provides a bonding structure 100. The bonding structure 100 may include a first power unit 110, a second power unit 120, and at least two bonding wires 140. At least one end of the bonding wire 140 is connected to the first power unit 110 through bonding.

In this embodiment of this application, the first power unit 110 may be a first substrate 112; or the first power unit 110 may be a first wafer 111; or the first power unit 110 may include a first substrate 112 and a first wafer 111 disposed on the first substrate 112.

The second power unit 120 may be a second substrate 122; or the second power unit 120 may be a second wafer 121; or the second power unit 120 may include a second substrate 122 and a second wafer 121 disposed on the second substrate 122.

There may be a plurality of first wafers 111. The plurality of first wafers 111 may be disposed on the first substrate 112 in a spaced manner, or the plurality of first wafers 111 may be disposed on the first substrate 112 in a laminated manner. The first wafer 111 may be welded to the first substrate 112 through welding, or the first wafer 111 may be fastened to the first substrate 112 by using a bonding layer material, or the first wafer 111 may be fastened to the first substrate 112 in another manner.

Similarly, there may be a plurality of second wafers 121. The plurality of second wafers 121 may be disposed on the second substrate 122 in a spaced manner, or the plurality of second wafers 121 may be disposed on the second substrate 122 in a laminated manner. The second wafer 121 may be welded to the second substrate 122 through welding, or the second wafer 121 may be fastened to the second substrate 122 by using a bonding layer material, or the second wafer 121 may be fastened to the second substrate 122 in another manner.

In this embodiment of this application, as shown in FIG. 1, an example in which the plurality of first wafers 111 are spaced on the first substrate 112 and the plurality of second wafers 121 are spaced on the second substrate 122 is used for description.

The bonding layer material includes but is not limited to the following materials: a conductive adhesive (for example, a conductive silver adhesive), a conductive film, and the like. In addition, the first substrate 112 and the second substrate 122 in this embodiment of this application may be copper substrates. The copper substrate has better heat dissipation effect and better heat conduction effect compared with an aluminum substrate and an iron substrate.

It should be noted that thicknesses, quantities, and the like of the first wafer 111, the second wafer 121, the first substrate 112, and the second substrate 122 are not limited in this embodiment of this application. In addition, a structure of the first power unit 110 and a structure of the second power unit 120 are not further limited. Specifically, an electrical connection can be implemented through the bonding wire 140 according to an actual situation.

The at least one end of the bonding wire 140 is connected to the first power unit 110 through bonding. The at least one end of the bonding wire 140 herein is described as follows: For example, the bonding wire 140 may include a bonding wire A and a bonding wire B. The bonding wire A includes a first end and a second end. The bonding wire B includes a first end and a second end. The at least one end of the bonding wire 140 includes the first end of the bonding wire A and the first end of the bonding wire B. In specific application, both the first end of the bonding wire A and the first end of the bonding wire B are connected to the first power unit 110 through bonding; and both the second end of the bonding wire A and the second end of the bonding wire B may also be connected to the first power unit 110 through bonding, or the second end of the bonding wire A and the second end of the bonding wire B may extend in a direction away from the first power unit 110. For example, both the second end of the bonding wire A and the second end of the bonding wire B are connected to the second power unit 120 through bonding.

In this embodiment of this application, a bonding connection manner of the at least two bonding wires 140 is described in detail in the following embodiments.

In specific application, as shown in FIG. 2 to FIG. 18, the first power unit 110 has at least two bonding points, and the at least two bonding wires 140 are connected to the at least two bonding points in a one-to-one correspondence through bonding. For example, the first power unit 110 may have a bonding point a1, a bonding point b1, a bonding point a2, and a bonding point b2. The first end of the bonding wire A is connected to the bonding point a1 through bonding. The first end of the bonding wire B is connected to the bonding point b1 through bonding. The second end of the bonding wire A is connected to the bonding point a2 through bonding. The second end of the bonding wire B is connected to the bonding point b2 through bonding. The bonding point a1 and the bonding point b1 are points led out from a same electrical point, and the bonding point a2 and the bonding point b2 are points led out from a same electrical point. It may be understood that the electrical point is an abstract concept, and is a point of a same voltage. Voltages of the bonding point a1 and the bonding point b1 are the same, and voltages of the bonding point a2 and the bonding point b2 are the same.

In this way, when a lead path of the bonding wire A is in a direction from a1 to b1, and a lead path of the bonding wire B is in a direction from a2 to b2, a current flow direction of the bonding wire A is the same as a current flow direction of the bonding wire B. Under acting force of mutually repulsive magnetic fields, the bonding wire A and the bonding wire B are stretched in directions away from each other. Therefore, the bonding points are prone to fatigue due to fluctuating stress, thereby affecting reliability of the bonding points.

Alternatively, when a lead path of the bonding wire A is in a direction from a1 to b1, and a lead path of the bonding wire B is in a direction from b2 to a2, a current flow direction on the bonding wire A is opposite to a current flow direction on the bonding wire B. Under acting force of mutually attractive magnetic fields, the bonding wire A and the bonding wire B approach each other in directions facing each other. Therefore, the bonding points are prone to fatigue due to fluctuating stress, thereby affecting reliability of the bonding points.

Therefore, to resolve problems that the bonding wires 140 are stretched, the bonding points are prone to fatigue due to fluctuating stress, and the like, in this embodiment of this application, projections that are of lead paths of the at least two bonding wires 140 and that are on a preset plane 130 have at least one intersection point. For the intersection point, refer to points D in FIG. 2 to FIG. 15. The projection includes an orthographic projection and an oblique projection. When a center line of projection lines of a projection is perpendicular to a projection plane, the projection is the orthographic projection. When a center line of projection lines of a projection is not perpendicular to a projection plane, the projection is referred to as the oblique projection. In this embodiment of this application, the projection is not limited to the orthographic projection or the oblique projection.

The projections that are of the lead paths of the at least two bonding wires 140 and that are on the preset plane 130 have at least one intersection point D. The intersection point may fall on a plane on which the first power unit 110 is located, and may fall on a plane other than the plane on which the first power unit 110 is located. In consideration of this, the preset plane 130 in this embodiment of this application is a reference plane introduced from the outside.

In specific application, an implementation is as follows: The preset plane 130 is parallel to the first power unit 110. Herein, parallel means that the preset plane 130 and the first power unit 110 are located on a same plane. In this case, the preset plane 130 is the plane on which the first power unit 110 is located. The at least one intersection point falls on the plane on which the first power unit 110 is located. Another implementation is as follows: There may be a distance between the preset plane 130 and the first power unit 110. The at least one intersection point may fall on the plane on which the first power unit 110 is located, or may fall on the preset plane 130.

In addition, in this embodiment of this application, a quantity of intersection points and a quantity of bonding wires 140 are not further limited.

For example, the projections that are of the lead paths of the at least two bonding wires 140 and that are on the preset plane 130 may have one intersection point, or the projections that are of the lead paths of the at least two bonding wires 140 and that are on the preset plane 130 may have two intersection points, or the projections that are of the lead paths of the at least two bonding wires 140 and that are on the preset plane 130 may have a plurality of intersection points. This is not further limited in this embodiment of this application.

For example, there may be two bonding wires 140, and projections that are of lead paths of the two bonding wires 140 and that are on the preset plane 130 have at least one intersection point. Alternatively, there may be three bonding wires 140, and projections that are of lead paths of any two of the three bonding wires 140 or two neighboring bonding wires 140 and that are on the preset plane 130 have at least one intersection point. Alternatively, there may be a plurality of bonding wires 140, and projections that are of lead paths of any two of the plurality of bonding wires 140 or two neighboring bonding wires 140 and that are on the preset plane 130 have at least one intersection point.

The lead path of the bonding wire 140 is described as follows: Because the bonding wire 140 in this embodiment of this application is in an arc shape, an understandable manner is that the lead path of the bonding wire 140 may be a lead of the bonding wire 140; and another understandable manner is that the lead path of the bonding wire 140 may be a lead extension line in a direction from one end of the bonding wire 140 to the other end of the bonding wire 140. It should be noted that this is not further limited in this embodiment of this application.

A working principle of a power module in this embodiment of this application is as follows: When an alternating current passes through the bonding wire 140, a magnetic field is induced around the bonding wire 140. The projections that are of the lead paths of the at least two bonding wires 140 and that are on the preset plane 130 are set to have the at least one intersection point. In this way, the bonding wires 140 can form an angle with each other, so that electromagnetic force between neighboring bonding wires 140 can be weakened. Therefore, fatigue due to fluctuating stress of the bonding wires 140 can be alleviated, service lives of the bonding wires 140 can be prolonged, and bonding effect can be ensured to a maximum extent.

It should be noted that spatial cross wire bonding is performed on the bonding wire A and the bonding wire B in this embodiment of this application. Therefore, as shown in FIG. 2 to FIG. 18, the bonding wire A in this embodiment of this application is described by using a solid line, and the bonding wire B is described by using a dashed line.

The following describes in detail a bonding connection manner of the bonding wires 140 in embodiments of this application with reference to FIG. 2 to FIG. 18 and Embodiment 1 to Embodiment 7.

### Embodiment 1

FIG. 2 is a schematic diagram of a structure in which bonding wires are bonded to a first wafer and an intersection point falls on a plane on which the first wafer is located according to Embodiment 1 of this application. FIG. 3 is a schematic diagram of a structure in which bonding wires are bonded to a first wafer and an intersection point falls on a preset plane according to Embodiment 1 of this application.

As shown in FIG. 2, two ends of the bonding wire 140 may be both connected to the first wafer 111 through bonding, and the preset plane 130 is the plane on which the first wafer 111 is located. Two bonding wires 140 are used as an example for description. The first end and the second end of the bonding wire A, and the first end and the second end of the bonding wire B are all connected to the first wafer 111 through bonding.

As shown in FIG. 2, the at least one intersection point falls on the plane on which the first wafer 111 is located, to implement an electrical connection between two devices in the first wafer 111. Alternatively, as shown in FIG. 3, the at least one intersection point falls on a plane other than the plane on which the first wafer 111 is located. To be specific, the at least one intersection point falls on the preset plane 130.

Similarly, as shown in FIG. 2, the two ends of the bonding wire 140 may be both connected to the second wafer 121 through bonding. The preset plane 130 is a plane on which the second wafer 121 is located. The at least one intersection point falls on the plane on which the second wafer 121 is located, to implement an electrical connection between two devices in the second wafer 121. Alternatively, the at least one intersection point falls on a plane other than the plane on which the second wafer 121 is located. To be specific, the at least one intersection point falls on the preset plane 130.

A connection method of the electrical connection between two devices in the first wafer 111 and the electrical connection between two devices in the second wafer 121 is not limited. The internal devices may be connected in series or in parallel to form a power loop, or the devices may be independent single devices. In this way, a quantity of devices can be effectively reduced, cabling space can be saved, and a size design can be optimized, thereby reducing a volume of the power device.

### Embodiment 2

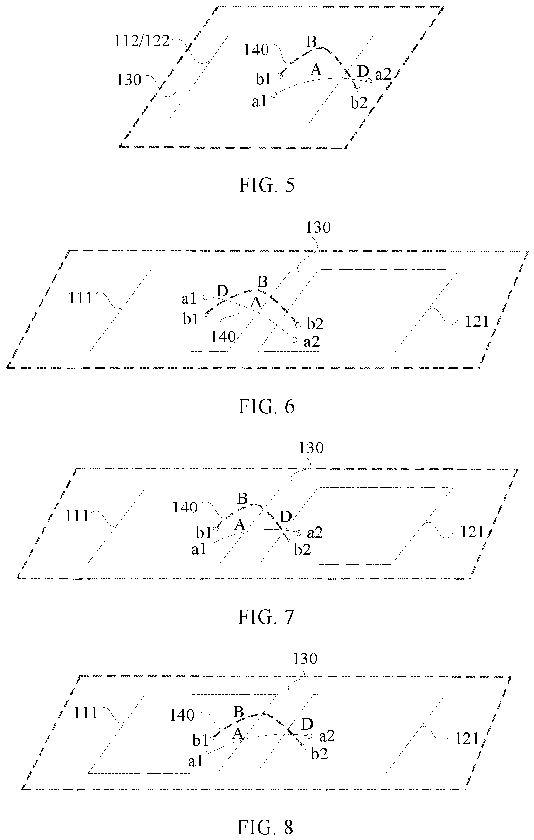

FIG. 4 is a schematic diagram of a structure in which bonding wires are bonded to a first substrate and an intersection point falls on a plane on which the first substrate is located according to Embodiment 2 of this application. FIG. 5 is a schematic diagram of a structure in which bonding wires are bonded to a first substrate and an intersection point falls on a preset plane according to Embodiment 2 of this application.

As shown in FIG. 4, two ends of the bonding wire 140 may be both connected to the first substrate 112 through bonding, and the preset plane 130 is the plane on which the first substrate 112 is located. Two bonding wires 140 are used as an example for description. The first end and the second end of the bonding wire A, and the first end and the second end of the bonding wire B are all connected to the first substrate 112 through bonding.

As shown in FIG. 4, the at least one intersection point falls on the plane on which the first substrate 112 is located, to implement an electrical connection between two devices in the first substrate 112. Alternatively, as shown in FIG. 5, the at least one intersection point falls on a plane other than the plane on which the first substrate 112 is located. To be specific, the at least one intersection point falls on the preset plane 130.

Similarly, the two ends of the bonding wire 140 may be both connected to the second substrate 122 through bonding. The preset plane 130 is a plane on which the second substrate 122 is located. The at least one intersection point falls within the plane on which the second substrate 122 is located, to implement an electrical connection between two devices in the second substrate 122. Alternatively, the at least one intersection point falls on a plane other than the plane on which the second substrate 122 is located. To be specific, the at least one intersection point falls on the preset plane 130.

Similarly, a connection method of the electrical connection between two devices in the first substrate 112 and the electrical connection between two devices in the second substrate 122 is not limited. The internal devices may be connected in series or in parallel to form a power loop, or the devices may be independent single devices. In this way, a quantity of devices can be effectively reduced, cabling space can be saved, and a size design can be optimized, thereby reducing a volume of the power device.

### Embodiment 3

FIG. 6 is a schematic diagram of a structure in which bonding wires are bonded to a first wafer and a second wafer and an intersection point falls on a plane on which the first wafer is located according to Embodiment 3 of this application. FIG. 7 is a schematic diagram of a structure in which bonding wires are bonded to a first wafer and a second wafer and an intersection point falls on a preset plane according to Embodiment 3 of this application. FIG. 8 is a schematic diagram of a structure in which bonding wires are bonded to a first wafer and a second wafer and an intersection point falls on a plane on which the second wafer is located according to Embodiment 3 of this application. As shown in FIG. 6, one end of the bonding wire 140 may be connected to the first wafer 111 through bonding, and the other end of the bonding wire 140 may be connected to the second wafer 121 through bonding. Two bonding wires 140 are used as an example for description. Both the first end of the bonding wire A and the first end of the bonding wire B are connected to the first wafer 111 through bonding. Both the second end of the bonding wire A and the second end of the bonding wire B are connected to the second wafer 121 through bonding. Therefore, an electrical connection can be implemented between the first wafer 111 and the second wafer 121.

It should be noted that, in this embodiment of this application, when the preset plane 130, the plane on which the first wafer 111 is located, and the plane on which the second wafer 121 is located are all on a same horizontal plane, the preset plane 130 is the plane on which the first wafer 111 is located or the plane on which the second wafer 121 is located. In this case, the intersection point may fall on the plane on which the first wafer 111 is located (as shown in FIG. 6); or the intersection point may fall on the plane on which the second wafer 121 is located (as shown in FIG. 8); or a plurality of intersection points may fall on the plane on which the first wafer 111 is located and the plane on which the second wafer 121 is located, or the intersection point may fall on the preset plane 130 (as shown in FIG. 7).

When the preset plane 130, the plane on which the first wafer 111 is located, and the plane on which the second wafer 121 is located are not on a same horizontal plane, for example, the plane on which the first wafer 111 is located may be higher than the plane on which the second wafer 121 is located, and the plane on which the second wafer 121 is located may be higher than the preset plane 130. The planes may be specifically set according to an actual situation. In this case, the intersection point may fall on the plane on which the first wafer 111 is located; or the intersection point may fall on the plane on which the second wafer 121 is located; or a plurality of intersection points may fall on the plane on which the first wafer 111 is located and the plane on which the second wafer 121 is located; or the intersection point may fall on the preset plane 130.

### Embodiment 4

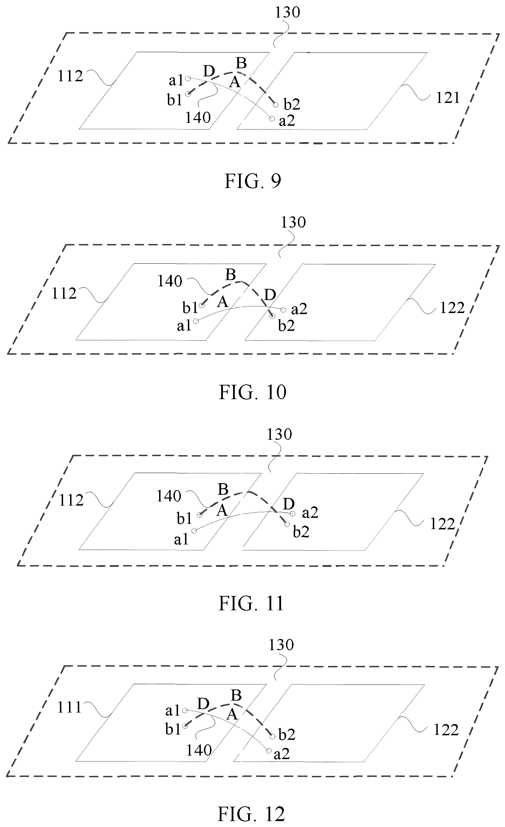

FIG. 9 is a schematic diagram of a structure in which bonding wires are bonded to a first substrate and a second substrate and an intersection point falls on a plane on which the first substrate is located according to Embodiment 4 of this application. FIG. 10 is a schematic diagram of a structure in which bonding wires are bonded to a first substrate and a second substrate and an intersection point falls on a preset plane according to Embodiment 4 of this application. FIG. 11 is a schematic diagram of a structure in which bonding wires are bonded to a first substrate and a second substrate and an intersection point falls on a plane on which the second substrate is located according to Embodiment 4 of this application.

As shown in FIG. 9, one end of the bonding wire 140 may be connected to the first substrate 112 through bonding, and the other end of the bonding wire 140 may be connected to the second substrate 122 through bonding. Two bonding wires 140 are used as an example for description. Both the first end of the bonding wire A and the first end of the bonding wire B are connected to the first substrate 112 through bonding, and both the second end of the bonding wire A and the second end of the bonding wire B are connected to the second substrate 122 through bonding. Therefore, an electrical connection can be implemented between the first substrate 112 and the second substrate 122.

Similarly, when the preset plane 130, the plane on which the first substrate 112 is located, and the plane on which the second substrate 122 is located are all on a same horizontal plane, the intersection point may fall on the plane on which the first substrate 112 is located (as shown in FIG. 9); or the intersection point may fall on the plane on which the second substrate 122 is located (as shown in FIG. 11); or a plurality of intersection points may fall on the plane on which the first substrate 112 is located and the plane on which the second substrate 122 is located, or the intersection point may fall on the preset plane 130 (as shown in FIG. 10).

When the preset plane 130, the plane on which the first substrate 112 is located, and the plane on which the second substrate 122 is located are not on a same horizontal plane, for example, the intersection point may fall on the plane on which the first substrate 112 is located; or the intersection point may fall on the plane on which the second substrate 122 is located; or a plurality of intersection points may fall on the plane on which the first substrate 112 is located and the plane on which the second substrate 122 is located; or the intersection point may fall on the preset plane 130.

### Embodiment 5

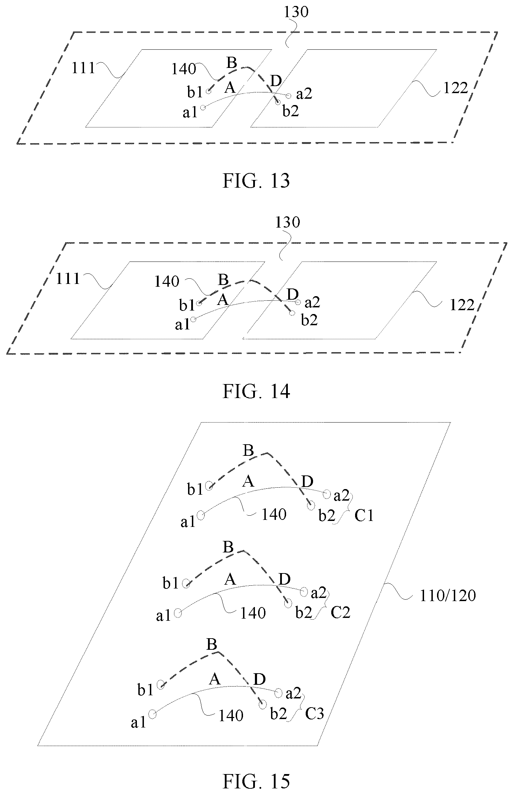

FIG. 12 is a schematic diagram of a structure in which bonding wires are bonded to a first wafer and a second substrate and an intersection point falls on a plane on which the first wafer is located according to Embodiment 5 of this application. FIG. 13 is a schematic diagram of a structure in which bonding wires are bonded to a first wafer and a second substrate and an intersection point falls on a preset plane according to Embodiment 5 of this application. FIG. 14 is a schematic diagram of a structure in which bonding wires are bonded to a first wafer and a second substrate and an intersection point falls on a plane on which the second substrate is located according to Embodiment 5 of this application.

As shown in FIG. 12, one end of the bonding wire 140 may be connected to the first wafer 111 through bonding, and the other end of the bonding wire 140 may be connected to the second substrate 122 through bonding. Two bonding wires 140 are used as an example for description. Both the first end of the bonding wire A and the first end of the bonding wire B are connected to the first wafer 111 through bonding, and both the second end of the bonding wire A and the second end of the bonding wire B are connected to the second substrate 122 through bonding. Therefore, an electrical connection can be implemented between the first wafer 111 and the second substrate 122.

The intersection point may fall on the plane on which the first wafer 111 is located (as shown in FIG. 12); or the intersection point may fall on the preset plane 130 (as shown in FIG. 13); or the intersection point may fall on the plane on which the second substrate 122 is located (as shown in FIG. 14).

Alternatively, one end of the bonding wire 140 may be connected to the first substrate 112 through bonding, and the other end of the bonding wire 140 may be connected to the second wafer 121 through bonding. Two bonding wires 140 are used as an example for description. Both the first end of the bonding wire A and the first end of the bonding wire B are connected to the first substrate 112 through bonding, and both the second end of the bonding wire A and the second end of the bonding wire B are connected to the second wafer 121 through bonding. Therefore, an electrical connection can be implemented between the first substrate 112 and the second wafer 121.

### Embodiment 6

FIG. 15 is a schematic diagram 1 of a structure in which bonding wires form bonding units according to Embodiment 6 of this application. FIG. 16 is a schematic diagram 2 of a structure in which bonding wires form bonding units according to Embodiment 6 of this application. FIG. 17 is a schematic diagram 3 of a structure in which bonding wires form bonding units according to Embodiment 6 of this application.

As shown in FIG. 15 to FIG. 17, a plurality of bonding wires 140 are included, the plurality of bonding wires 140 form bonding units, and the plurality of bonding units are spaced in an arrangement direction of at least two bonding points. It should be noted that a quantity of bonding wires 140 forming the bonding units is not limited.

For example, as shown in FIG. 15 and FIG. 16, two of the plurality of bonding wires 140 form each of a bonding unit C1, a bonding unit C2, a bonding unit C3, and the like. The bonding unit C1, the bonding unit C2, and the bonding unit C3 are arranged in an arrangement direction of bonding points through bonding.

Alternatively, as shown in FIG. 17, three of the plurality of bonding wires 140 form each of a bonding unit C1, a bonding unit C2, a bonding unit C3, and the like. The bonding unit C1, the bonding unit C2, the bonding unit C3, and the like are arranged in an arrangement direction of bonding points through bonding.

Alternatively, the plurality of bonding wires 140 form each of a bonding unit C1, a bonding unit C2, a bonding unit C3, and the like. The bonding unit C1, the bonding unit C2, and the bonding unit C3 are arranged in an arrangement direction of bonding points through bonding.

In specific application, an implementable arrangement manner is as follows: As shown in FIG. 15, projections that are of lead paths of at least two bonding wires 140 in each bonding unit and that are on the preset plane 130 have at least one intersection point. For example, two of the plurality of bonding wires 140 form each of a bonding unit C1, a bonding unit C2, and a bonding unit C3. Projections that are of a bonding wire A and a bonding wire B in the bonding unit C1 and that are on the preset plane 130 have an intersection point D. Projections that are of a bonding wire A and a bonding wire B in the bonding unit C2 and that are on the preset plane 130 have an intersection point D. In addition, projections that are of a bonding wire A and a bonding wire B in the bonding unit C3 and that are on the preset plane 130 have an intersection point D.

Another implementable arrangement manner is as follows: As shown in FIG. 16, projections that are of lead paths of at least two bonding wires 140 in at least one of the plurality of bonding units and that are on the preset plane 130 have at least one intersection point, and lead paths of at least two bonding wires 140 in a remaining bonding unit have no intersection point. Having no intersection point means that the lead paths of the at least two bonding wires 140 may be in a parallel state, or the lead paths of the at least two bonding wires 140 may be in another non-intersecting state. This shall fall within the protection scope of this application provided that there is no intersection point. For example, lead paths of a bonding wire A and a bonding wire B in the bonding unit C1 and lead paths of a bonding wire A and a bonding wire B in the bonding unit C2 are in parallel. Projections that are of lead paths of a bonding wire A and a bonding wire B in the bonding unit C3 and that are on the preset plane 130 have an intersection point D.

Still another implementable arrangement manner is as follows: As shown in FIG. 17, at least three of the plurality of bonding wires 140 form a bonding unit. Projections that are of lead paths of at least two of the at least three bonding wires 140 and that are on the preset plane 130 have no intersection point. A projection that is of a lead path of another bonding wire 140 and that is on the preset plane 130 and the projections that are of the lead paths of the at least two bonding wires 140 and that are on the preset plane 130 each have at least one intersection point. For example, the bonding unit C1 includes a bonding wire A1, a bonding wire A2, and the bonding wire B. Lead paths of the bonding wire A1 and the bonding wire A2 are in parallel. Projections that are of lead paths of the bonding wire B and the bonding wire A1 and that are on the preset plane 130 have an intersection point D1. Projections that are of lead paths of the bonding wire B and the bonding wire A2 and that are on the preset plane 130 have an intersection point D2.

It should be noted that this embodiment of this application includes but is not limited to the foregoing arrangement manners. In addition, the arrangement direction of the bonding points is not further limited. For example, at least two bonding points may be arranged in a lateral direction of the first power unit 110, or may be arranged in a longitudinal direction of the first power unit 110. Alternatively, when there are a plurality of bonding points, the bonding points may be arranged in an inclined manner. Specifically, the bonding points may be arranged according to an actual situation.

### Embodiment 7

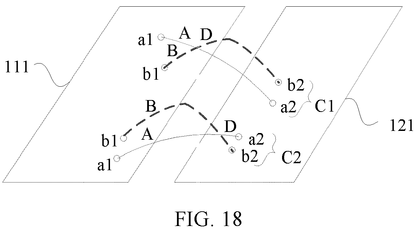

FIG. 18 is a schematic diagram of a structure in which a maximum height of bonding wires is different from a maximum height of a first power unit according to Embodiment 7 of this application.

As shown in FIG. 18, in an implementation, maximum distances between any two of the plurality of bonding wires 140 and a plane on which the first power unit 110 is located are different. In another implementation, maximum distances between at least two bonding wires 140 forming a bonding unit and a plane on which the first power unit 110 is located are different.

The first wafer 111 and the second wafer 121 are used as an example for description. The bonding wires 140 include the bonding wire A and the bonding wire B. A maximum distance between the bonding wire A and a plane on which the first wafer 111 is located may be greater than a maximum distance between the bonding wire B and the plane on which the first wafer 111 is located. Alternatively, a maximum distance between the bonding wire A and a plane on which the first wafer 111 is located may be less than a maximum distance between the bonding wire B and the plane on which the first wafer 111 is located.

For example, as shown in FIG. 18, in a bonding unit C1 group, on a side that of an intersection point D and that is close to the first wafer 111, the bonding wire A is located above the bonding wire B; and on a side that of the intersection point D and that is close to the second wafer 121, the bonding wire B is located above the bonding wire A. In a bonding unit C2 group, on a side that is of an intersection point D and that is close to the first wafer 111, the bonding wire A is located below the bonding wire B; and on a side that is of the intersection point D and that is close to the second wafer 121, the bonding wire A is located above the bonding wire B.

Similarly, maximum distances between the at least two bonding wires 140 and a plane on which a first substrate 112 is located may be different, or maximum distances between the at least two bonding wires 140 and a plane on which the second wafer 121 is located or a plane on which the second substrate 122 is located may be different.

The maximum distances between the at least two bonding wires 140 and the plane on which the first power unit 110 is located are set to be different, so that electromagnetic force between neighboring bonding wires 140 can also be weakened when an alternating current passes through the bonding wires 140. Therefore, fatigue due to fluctuating stress of the bonding wire 140 can be alleviated, service lives of the bonding wires 140 can be prolonged, and bonding effect can be ensured to a maximum extent.

Alternatively, the maximum distances between any two of the plurality of bonding wires 140 and the plane on which the first power unit 110 is located are the same. This also falls within the protection scope of this embodiment of this application. This is not further limited in this embodiment of this application.

An embodiment of this application further provides a power device. The power device includes the bonding structure 100 in the foregoing embodiments.

The power device in this embodiment of this application is also referred to as a power semiconductor device, and is mainly an electronic component with a relatively large output power, for example, a high-power transistor, a thyristor, a bidirectional thyristor, or an insulated gate bipolar transistor.

The power device may include a structure other than the bonding structure 100, for example, a circuit board, a heat sink, or a power supply. A mounting surface of the power device is mounted to the circuit board to implement an electrical connection. The heat sink is configured to dissipate heat for the power device. The power supply may supply power to the circuit board and the power device, to maintain normal working of the circuit board and the power device.

The power device provided in this embodiment of this application includes the foregoing bonding structure 100. The bonding structure 100 includes a first power unit 110 and bonding wires 140. At least one end of the bonding wire 140 is connected to the first power unit 110 through bonding. Therefore, an electrical connection can be implemented between two devices in the first power unit 110 or between the first power unit 110 and a neighboring power module such as a second power unit 120, to form a power current loop. The bonding structure 100 includes the at least two bonding wires 140. Projections that are of lead paths of the at least two bonding wires 140 and that are on a preset plane 130 have at least one intersection point. In this way, the bonding wires 140 can form an angle with each other, so that electromagnetic force between neighboring bonding wires 140 can be weakened when an alternating current passes through the bonding wires 140. Therefore, fatigue due to fluctuating stress of the bonding wires 140 can be alleviated, service lives of the bonding wires 140 can be prolonged, and bonding effect can be ensured to a maximum extent.

In the description of this application, it should be noted that, unless otherwise clearly specified and limited, the terms "mount", "link", and "connect" should be understood in a broad sense. For example, the connection may be a fixed connection, may be an indirect connection by using an intermediate medium, or may be an internal connection between two elements or an interaction relationship between two elements. Persons of ordinary skill in the art may interpret specific meanings of the foregoing terms in this application according to specific situations.

An apparatus or element in this application, or an apparatus or element implied in this application needs to have a specific orientation or be constructed and operated in a specific orientation, and therefore cannot be understood as a limitation on this application. In the description of this application, "a plurality of" means two or more than two, unless otherwise precisely and specifically specified.

In the specification, claims, and accompanying drawings of this application, terms "first", "second", "third", "fourth", and the like (if existent) are intended to distinguish between similar objects but do not necessarily indicate a specific order or sequence. It should be understood that data termed in such a way is interchangeable in proper circumstances, so that embodiments of this application described herein can be, for example, implemented in an order other than the order illustrated or described herein. In addition, the terms "include", "have", and any other variant thereof are intended to cover the non-exclusive inclusion. For example, a process, method, system, product, or device that includes a list of steps or units is not necessarily limited to those steps or units that are expressly listed, but may include other steps or units that are not expressly listed or inherent to the process, method, product, or device.

## Claims

1. A bonding structure, comprising a first power unit (110) and at least two bonding wires (140), wherein
at least one end of the bonding wire (140) is connected to the first power unit (110) through bonding, and projections that are of lead paths of the at least two bonding wires (140) and that are on a preset plane (130) have one intersection point, wherein the preset plane (130) is parallel to the first power unit (110);
wherein the first power unit (110) has at least two bonding points (a11, a12, a21, a22, b1, b2), and the at least two bonding wires (140) are connected to the at least two bonding points (a11, a12, a21, a22, b1, b2) in a one-to-one correspondence through bonding;
wherein the at least two bonding wires (140) form a plurality of bonding units (C1, C2), and the plurality of bonding units (C1, C2) are spaced in an arrangement direction of the at least two bonding points (a11, a12, a21, a22, b1, b2);
wherein at least three (A1, A2, B) of the at least two bonding wires (140) form the bonding unit (C1, C2); and **characterized in that**,
projections that are of lead paths of at least two of the at least three bonding wires (A1, A2) and that are on the preset plane (130) have no intersection point, and a projection that is of a lead path of another bonding wire (B) and that is on the preset plane (130) and each of the projections that are of the lead paths of the at least two of the at least three bonding wires (A1, A2) and that are on the preset plane (130) have one intersection point (D1, D2).

2. The bonding structure according to claim 1, wherein one end of the bonding wire (140) is connected to the first power unit (110) through bonding, and the other end of the bonding wire (140) is connected to the outside of the first power unit through bonding.

3. The bonding structure according to claim 1, wherein two ends of the bonding wire (140) are both connected to the first power unit (110) through bonding, and the preset plane (130) is a plane on which the first power unit (110) is located.

4. The bonding structure according to claim 2, further comprising a second power unit (120), wherein one end of the bonding wire (140) is connected to the first power unit (110) through bonding, and the other end of the bonding wire (140) is connected to the second power unit (120) through bonding.

5. The bonding structure according to any one of claims 1 to 4, wherein the first power unit (110) is a first substrate; or the first power unit (110) is a first wafer; or the first power unit (110) comprises a first substrate and a first wafer disposed on the first substrate, and the bonding wire (140) is connected to the first wafer through bonding.

6. The bonding structure according to claim 4, wherein the second power unit (120) is a second substrate; or the second power unit (120) is a second wafer; or the second power unit (120) comprises the second substrate and the second wafer disposed on the second substrate, and the bonding wire (140) is connected to the second wafer through bonding.

7. A power device, comprising the bonding structure according to any one of claims 1 to 6.

## Patentansprüche

1. Bondstruktur, umfassend eine erste Stromversorgungseinheit (110) und mindestens zwei Bonddrähte (140), wobei
mindestens ein Ende des Bonddrahts (140) mit der ersten Stromversorgungseinheit (110) durch Bonden verbunden ist und Projektionen, die von Anschlusspfaden der mindestens zwei Bonddrähte (140) stammen und die sich auf einer vorgegebenen Ebene (130) befinden, einen Schnittpunkt aufweisen, wobei die vorgegebene Ebene (130) parallel zu der ersten Stromversorgungseinheit (110) ist;
wobei die erste Stromversorgungseinheit (110) mindestens zwei Bondpunkte (a11, a12, a21, a22, b1, b2) aufweist und die mindestens zwei Bonddrähte (140) mit den mindestens zwei Bondpunkten (a11, a12, a21, a22, b1, b2) in einer Eins-zu-eins-Entsprechung durch Bonden verbunden sind;
wobei die mindestens zwei Bonddrähte (140) eine Vielzahl von Bondeinheiten (C1, C2) bilden und die Vielzahl von Bondeinheiten (C1, C2) in einer Anordnungsrichtung der mindestens zwei Bondpunkte (a11, a12, a21, a22, b1, b2) beabstandet sind;
wobei mindestens drei (A1, A2, B) der mindestens zwei Bonddrähte (140) die Bondeinheit (C1, C2) bilden; und **dadurch gekennzeichnet, dass**,
Projektionen, die von Anschlusspfaden von mindestens zwei der mindestens drei Bonddrähte (A1, A2) stammen und die sich auf der voreingestellten Ebene (130) befinden, keinen Schnittpunkt aufweisen, und eine Projektion, die von einem Anschlusspfad eines anderen Bonddrahts (B) stammt und die sich auf der voreingestellten Ebene (130) befindet, und jede der Projektionen, die von den Anschlusspfaden der mindestens zwei der mindestens drei Bonddrähte (A1, A2) stammen und die sich auf der voreingestellten Ebene (130) befinden, einen Schnittpunkt (D1, D2) aufweisen.

2. Bondstruktur nach Anspruch 1, wobei ein Ende des Bonddrahts (140) mit der ersten Stromversorgungseinheit (110) durch Bonden verbunden ist und das andere Ende des Bonddrahts (140) mit der Außenseite der ersten Stromversorgungseinheit durch Bonden verbunden ist.

3. Bondstruktur nach Anspruch 1, wobei zwei Enden des Bonddrahts (140) beide mit der ersten Stromversorgungseinheit (110) durch Bonden verbunden sind und die voreingestellte Ebene (130) eine Ebene ist, auf der sich die erste Stromversorgungseinheit (110) befindet.

4. Bondstruktur nach Anspruch 2, ferner umfassend eine zweite Stromversorgungseinheit (120), wobei ein Ende des Bonddrahts (140) mit der ersten Stromversorgungseinheit (110) durch Bonden verbunden ist und das andere Ende des Bonddrahts (140) mit der zweiten Stromversorgungseinheit (120) durch Bonden verbunden ist.

5. Bondstruktur nach einem der Ansprüche 1 bis 4, wobei die erste Stromversorgungseinheit (110) ein erstes Substrat ist; oder die erste Stromversorgungseinheit (110) ein erster Wafer ist; oder die erste Stromversorgungseinheit (110) ein erstes Substrat und einen ersten Wafer, der auf dem ersten Substrat angeordnet ist, umfasst und der Bonddraht (140) mit dem ersten Wafer durch Bonden verbunden ist.

6. Bondstruktur nach Anspruch 4, wobei die zweite Stromversorgungseinheit (120) ein zweites Substrat ist; oder die zweite Stromversorgungseinheit (120) ein zweiter Wafer ist; oder die zweite Stromversorgungseinheit (120) das zweite Substrat und den zweiten Wafer, der auf dem zweiten Substrat angeordnet ist, umfasst und der Bonddraht (140) mit dem zweiten Wafer durch Bonden verbunden ist.

7. Stromversorgungsvorrichtung, umfassend die Bondstruktur nach einem der Ansprüche 1 bis 6.

## Revendications

1. Structure de liaison, comprenant une première unité d'alimentation (110) et au moins deux fils de liaison (140), dans laquelle
au moins une extrémité du fil de liaison (140) est connectée à la première unité d'alimentation (110) par liaison, et des projections qui sont des trajectoires de conduction des au moins deux fils de liaison (140) et qui sont sur un plan prédéfini (130) présentent un point d'intersection, dans lequel le plan prédéfini (130) est parallèle à la première unité d'alimentation (110) ;
dans laquelle la première unité d'alimentation (110) présente au moins deux points de liaison (a11, a12, a21, a22, b1, b2), et les au moins deux fils de liaison (140) sont connectés aux au moins deux points de liaison (a11, a12, a21, a22, b1, b2) dans une correspondance biunivoque par liaison ;
dans laquelle les au moins deux fils de liaison (140) forment une pluralité d'unités de liaison (C1, C2), et la pluralité d'unités de liaison (C1, C2) sont espacées dans une direction d'agencement des au moins deux points de liaison (a11, a12, a21, a22, b1, b2) ;
dans laquelle au moins trois (A1, A2, B) des au moins deux fils de liaison (140) forment l'unité de liaison (C1, C2) ; et **caractérisée en ce que**,
des projections qui sont des trajectoires de conduction d'au moins deux des au moins trois fils de liaison (A1, A2) et qui sont sur le plan prédéfini (130) ne présentent pas de point d'intersection, et une projection qui est d'une trajectoire de conduction d'un autre fil de liaison (B) et qui est sur le plan prédéfini (130) et chacune des projections qui sont des trajectoires de conduction des au moins deux des au moins trois fils de liaison (A1, A2) et qui sont sur le plan prédéfini (130) présentent un point d'intersection (D1, D2).

2. Structure de liaison selon la revendication 1, dans laquelle une extrémité du fil de liaison (140) est connectée à la première unité d'alimentation (110) par liaison, et l'autre extrémité du fil de liaison (140) est connectée à l'extérieur de la première unité d'alimentation par liaison.

3. Structure de liaison selon la revendication 1, dans laquelle deux extrémités du fil de liaison (140) sont toutes deux connectées à la première unité d'alimentation (110) par liaison, et le plan prédéfini (130) est un plan sur lequel la première unité d'alimentation (110) est située.

4. Structure de liaison selon la revendication 2, comprenant également une seconde unité d'alimentation (120), dans laquelle une extrémité du fil de liaison (140) est connectée à la première unité d'alimentation (110) par liaison, et l'autre extrémité du fil de liaison (140) est connectée à la seconde unité d'alimentation (120) par liaison.

5. Structure de liaison selon l'une quelconque des revendications 1 à 4, dans laquelle la première unité d'alimentation (110) est un premier substrat ; ou la première unité d'alimentation (110) est une première plaquette ; ou la première unité d'alimentation (110) comprend un premier substrat et une première plaquette disposée sur le premier substrat, et le fil de liaison (140) est connecté à la première plaquette par liaison.

6. Structure de liaison selon la revendication 4, dans laquelle la seconde unité d'alimentation (120) est un second substrat ; ou la seconde unité d'alimentation (120) est une seconde plaquette ; ou la seconde unité d'alimentation (120) comprend le second substrat et la seconde plaquette disposée sur le second substrat, et le fil de liaison (140) est connecté à la seconde plaquette par liaison.

7. Dispositif d'alimentation, comprenant la structure de liaison selon l'une quelconque des revendications 1 à 6.
